# EUROPEAN PATENT APPLICATION

(11) **EP 0 680 081 A2**
(43) Date of publication of application: **02.11.1995**
(21) Application number: 95302740.6
(22) Date of filing: 24.04.1995
(51) Int. Cl.: H01L 21/428, H01L 21/4757, H01L 51/30

(54) **Method of forming thin film and electronic device using thin film**

(30) Priority: 25.04.1994 JP 86196/94
(71) Applicant: HITACHI, LTD., Chiyoda-ku, Tokyo 101 (JP)
(72) Inventor: Miwa, Takao, Hitachinaka-shi, Ibaraki 312 (JP); Matsuda, Minoru, Sendai-shi, Miyagi 981 (JP); Watanabe, Akira, Sendai-shi, Miyagi 980 (JP)
(74) Representative: Paget, Hugh Charles Edward

(57) **Abstract**

A thin film of Si or Ge network polymer is formed on a substrate and irradiated with electromagnetic radiation, then heat-treated at 200 to 1000°C. Thereby, it is possible to form a thin film having a function of electric conductivity (SiC), semiconductor property (a-Si), insulating property (SiO₂) or transparent property (SiO₂) on a substrate as desired easily.

## Description

### Background of the Invention

The present invention relates to a method of forming a thin film, and an electronic device using the thin film, and a method of manufacturing the electronic device.

With high-integration of semiconductor devices, the wave-length of irradiating light used for photo-lithography steadily becomes shorter to cope with minuscule pathways of the semiconductor devices. In the past, the irradiating light used for photo-lithography has been mainly a g-line (436 nm) which is one of characteristic emission light spectrums of a mercury lamp. However, in recent years, an i-line (365 nm) having a more advantageous characteristic in fine work is gradually being used widely. The etching process to form a pattern employs wet etching using a solvent or dry etching using a reactive gas.

The trend toward the minuscule pathway of the semiconductor devices naturally further progresses. However, the conventional photoresist of an organic material as a major constituent is not suitable for the lithography using light having a shorter wave-length than 350 nm since it strongly absorbs the light having a wave-length shorter than 350 nm.

Main candidates as the light source used for the above process are excimer lasers such as deep UV laser having a wave-length shorter than 300 nm, KrF laser (248 nm) and Ar laser (193 nm). Much attention is now focused on the combination of the above light source and polysilyne having the sensitivity in the range of wavelength described above. The etching process to form a pattern using the polysilyne resist also employs wet etching using a solvent or dry etching using a reactive gas (SPIE, Vol.1466, page 211 (1991)).

Further, in order to form an active device such as rectifier element on an inorganic substrate for a semiconductor device, the manufacturing processing includes more complex processes such as impurity diffusion process, ion implantation process and so on in addition to the wiring forming process described above.

Since forming a light wave guide requires further complex processes such as etching, coating and so on, there are problems in the production efficiency and in the production yield of the electronic devices.

The wet etching process for pattern forming described above has a problem in that a large amount of an organic solvent is used. There is also a problem in that a micro-pattern cannot be formed due to an inferior resolution in the edge portion of the pattern. Furthermore, in the dry etching process, there is a problem in that a special and expensive apparatus is required and the throughput of the process is low.

Especially, the resist having polysilyne as a major constituent requires to use a large amount of an organic solvent such as xylene or toluene in the wet etching process although the resist is capable of performing lithography using light having wave-length shorter than 350 nm. Since these organic solvents are flammable and toxic, these organic solvents become an obstacle against the commercial production. On the other hand, in the dry etching process, there is also a problem in that it requires to use a strong toxic gas such as HBr or the like. Although silicon group materials typical of SiO₂ are important as a material for an insulation film, SiO₂ will possibly become an obstacle to improve the performance of semiconductor devices in the future. There is also a problem in the productivity of a semiconductor device using an SiO₂ film since forming an SiO₂ film requires an apparatus such as CVD. For this problem, there is a siloxane group material of application type called as spin on glass (SOG). However, the SOG has a disadvantage in that the SOG can form a film having only a thickness of sub-micrometer order due to generation of a large stress during curing and the material as an inferior workability and is apt to crack.

### Summary of the Invention

One of the objects of the present invention is, under the circumstances described above, to provide a method of forming a pattern capable of safely and efficiently forming a fine pattern using light having a wave-length shorter than 350 nm.

Another object of the present invention is to provide a method of forming a thin film such as a conductor film (SiC), a semiconductor film (a-Si), an insulator film (SiO₂), a transparent film (SiO₂) on a substrate, and to provide a material for insulator film having a superior film characteristic and a superior workability, and to provide an electronic device having these films.

The present invention in various aspects is as follows.
(1) A method of forming a thin film, the method comprising the steps of forming a thin film of silicon network polymer on a substrate, irradiating electromagnetic wave on the film if necessary, and then heat-treating the substrate at 200°C to 1000°C.
(2) A method of forming a thin film, the method comprising the steps of forming a thin film of silicon network polymer on a substrate performing at least one of (1) process for irradiating electromagnetic wave on the film under an oxygen containing atmosphere and (2) process for heat-treating the substrate at 200°C to 1000°C under an oxygen containing atmosphere.
(3) A method of forming a thin film in the above process (1) or (2), wherein the silicon network polymer is a material formed by polymerizing organometallic compounds expressed by the following chemical equations [1] and [2]. 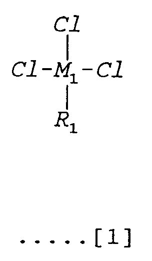 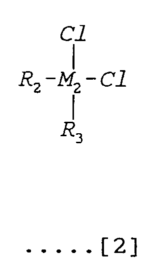 (Therein, M₁, M₂ are selected from the group consisting of Si and Ge, and may be the same. R₁, R₂, R₃ are each selected from the group consisting of aliphatic group, aliphatic fluoride group, aromatic group and aromatic fluoride group which have less than twenty carbon elements, and may be the same or different).
(4) A method of forming a thin film, wherein the silicon network polymer is a material formed by polymerizing organometallic compounds expressed by the following chemical equations [1] and [2] using alkali metal or alkali metal alloy, copper and magnesium.
(5) An insulator thin film formed by the steps of forming a thin film of silicon network polymer on a substrate, irradiating electromagnetic wave on the film under an oxygen containing atmosphere if necessary, and then heat-treating the substrate at 200°C to 1000°C.
(6) A method of forming an insulator thin film, the method comprising the steps of forming a thin film of silicon network polymer on a substrate, irradiating electromagnetic wave on the film under an oxygen containing atmosphere if necessary, and then heat-treating the substrate at 200°C to 1000°C.
(7) An integrated circuit having an insulator thin film as an inter layer dielectric film including surface dielectric layer, wherein the insulator thin film is formed by the steps of forming a thin film of silicon network polymer on a substrate, irradiating electromagnetic wave on the film under an oxygen containing atmosphere if necessary, and then heat-treating the substrate at 200°C to 1000°C.
(8) A method of manufacturing an integrated circuit having an insulator thin film as an inter layer dielectric including surface layer dielectric, wherein the insulator thin film is formed by the steps of forming a thin film of silicon network polymer on a substrate, irradiating electromagnetic wave on the film under an oxygen containing atmosphere if necessary, and then heat-treating the substrate at 200°C to 1000°C.
(9) An integrated circuit having an insulator thin film as an inter layer dielectric, wherein the insulator thin film is formed by the steps of forming a thin film of silicon network polymer on a substrate, irradiating electromagnetic wave on the film under an oxygen containing atmosphere if necessary, heat-treating the substrate at 200°C to 1000°C, and flattening the surface of said insulator thin film through chemical-mechanical polishing.
(10) A method of manufacturing an integrated circuit having an insulator thin film as an inter layer dielectric, wherein the insulator thin film is formed by the steps of forming a thin film of silicon network polymer on a substrate, irradiating electromagnetic wave on the film under an oxygen containing atmosphere if necessary, heat-treating the substrate at 200°C to 1000°C, and flattening the surface of said insulator thin film through chemical-mechanical polishing.
(11) An electronic device having a thin film used for a conductor layer or semiconductor layer, wherein the thin film is formed by the steps of forming a thin film of silicon network polymer on a substrate, irradiating electromagnetic wave on the film under an oxygen containing atmosphere if necessary, and then heat-treating the substrate at 200°C to 1000°C.
(12) A method of manufacturing an electronic device having a thin film used for a conductor layer or semiconductor layer, wherein the thin film is formed by the steps of forming a thin film of silicon network polymer on a substrate, irradiating electromagnetic wave on the film under an oxygen containing atmosphere if necessary, and then heat-treating the substrate at 200°C to 1000°C.
(13) A method of forming an insulator film, the method comprising the steps of forming a thin film of silicon network polymer on a substrate, and then oxidizing said thin film.
(14) An insulator film, which is formed by the steps of forming a thin film of silicon network polymer on a substrate, and then oxidizing said thin film.

The present invention can provide a process of using a material of which properties such as thermal resistivity is changed by irradiating electromagnetic wave, performing irradiation of electromagnetic wave and heat treatment, and forming a fine pattern without conventional wet etching or dry etching. Further, in some cases, it is possible to form a useful thin film only with heat treatment. Furthermore, there is an advantageous characteristic to improve performance of an electronic device by lowering dielectric property using net work polysilane having alkyl fluoride group. The synthesis of the-polysilane having alkyl fluoride group is described in Polymer Preprints, Japan, Vol.40, No.7, page 2191 (1991), and Japanese Patent Application Laid-Open No.3-258834 (1991). However, these relate to polysilane straight chain type, and are different from the present invention.

In order to change thermal property by irradiating electromagnetic wave or the like, it is necessary to use a material which causes photo-oxidation, photo-oxidative cross-link reaction, photo-decomposition.

The operation of the present invention will be described, referring to a case of utilizing photo-oxidative cross-link reaction of silicon network polymer as an example. In the present invention, the intermetallic compounds having Ge as the center metal are called as silicon network polymer for convenience's sake.

One example of the invention is as follows.

Silicon network polymer solved in an organic solvent such as toluene is applied onto an substrate to be formed a pattern through spin coat method or the like, and then dried to form a uniform thin film of silicon network polymer. Next, as electromagnetic wave having wavelength of 350 to 150 nm is irradiated on this thin film under an oxygen containing atmosphere, the exposed portion of the film changes into a structure containing much SiO skeletons by breaking of Si-Si linkage of the polysilyne and bonding with oxygen. In this process, the volume of the polysilyne according to the present invention expands with capturing the oxygen into its structure. Then, as it is heat-treated at 200 to 1000°C under vacuum, the silicon network polymer in the unexposed portion is decomposed and dispersed from the substrate, or is changed to a semiconductor thin film such as SiC, amorphous Si or the like. The silicon network polymer is not decomposed nor changed into SiC or amorphous Si under the temperature lower than 200°C because it is stable in that temperature range.

On the other hand, since Si-O skeleton having a strong thermal resistivity is formed in the exposed portion, the silicon network polymer in the exposed portion remains on the substrate even after heat treatment to form a pattern as a result. When the temperature is higher than 1000°C, the silicon network polymer in the exposed portion is also evaporated and consequently no thin film is obtained.

The same process has been applied to a conventional polysilyne of straight chain type. Both of the polysilyne film in the exposed portion and the polysilyne film in the unexposed portion are eliminated from an inorganic substrate after the above heat treatment. This means that the polysilyne of straight chain type has a low thermal resistivity.

The thermal stability of the silicon network polymer according to the present invention can be controlled by changing the mixing ratio in the polymerization of the organometallic compounds expressed by the equations [1] and [2]. The thermal stability is increased by increasing the mixing ratio of the component expressed by the equation [1]. In a case where fine pattern is not specially required, in the present invention, the exposing process may be omitted. For example, an insulator film having a superior property can be obtained by heat-treating a network polysilane formed in an oxygen atmosphere at 100 to 1000°C. It is also possible to obtain a superior insulator film only through exposing process by photo-oxidizing network polysilane in an oxygen atmosphere. It is no need to say that the photo-reaction and the thermal reaction can be used properly or can be combined properly as the occasion of necessity. The volume expansion due to oxidative reaction can be controlled by the degrees of photo-oxidation and thermal oxidation and the degree of thermal decomposition of organic group. Accordingly, the volume expansion of the silicon network polymer can be eliminated, and the volume can be also contracted. On occasion of using the formed film, the mechanical property of the film becomes important. In a case where the formed film contracts during forming process, a tensile film stress takes place in the film and a small shock initiates to produce cracks because the film is very brittle. On the other hand, in a case where the formed film expands during forming process, a compressive film stress takes place in the film, and accordingly it is advantageous to perform film work because cracks are hardly produced. The film according to the present invention having a structure containing many SiO skeletons is capable of controlling the film stress and, therefore, is a better material for each of film forming processes. From the standpoint of crack resistivity, it is preferable to allow the film to expand or to minimize the contraction of the film during the film forming process. Since the thin film according to the present invention is superior in applying characteristic and in film characteristic, there is no special limitation in the thickness of film to be formed. However, films having a uniform thickness have been easily obtained when the thickness is between 0.1 µm to 10 µm through spin coating method.

### Brief Description of the Drawings

FIG.1 is a graph showing the infrared spectrums of a poly(phenyl silyne) thin film after heat treatment in the exposed portion and the unexposed portion.

FIG.2 is a graph showing the current-voltage characteristic of an n-type silicon substrate/ SiC thin film.

FIG.3 is a graph showing a far infrared spectrum of a poly(n-propyl silyne) thin film after heat treatment in the unexposed portion.

FIG.4 is a graph showing the current-voltage characteristic of a p-n junction in a p-doped amorphous silicon formed from precursors of n-type silicon and poly(n-propyl silyne).

FIG.5 is a schematic cross-sectional view showing an aluminum double-layered wiring formed on a silicon wafer.

### Detailed Description of the Preferred Embodiments

The present invention will be described in detail below.

### [Embodiment 1]

Poly(phenyl silyne) is synthesized using only the compound shown in the equation [1] (R₁ is phenyl group), and a solution of the poly(phenyl silyne) of 20 wt% in toluene is coated on a silicon wafer with spin coating method. The specimen is exposed using a 500 W mercury lamp through a mask pattern under a oxygen containing atmosphere for 10 minutes, and then heat-treated at 700°C in a vacuum for 1 hour.

As the result, a negative pattern (thickness of 1.5 µm) having an L/S (line to space)=0.75 µm at minimum in the exposed portion to in the unexposed portion can be formed. As the negative pattern is observed using a microscope, it can be observed no crack and it is confirmed that the formed pattern is extremely close-grained and uniform.

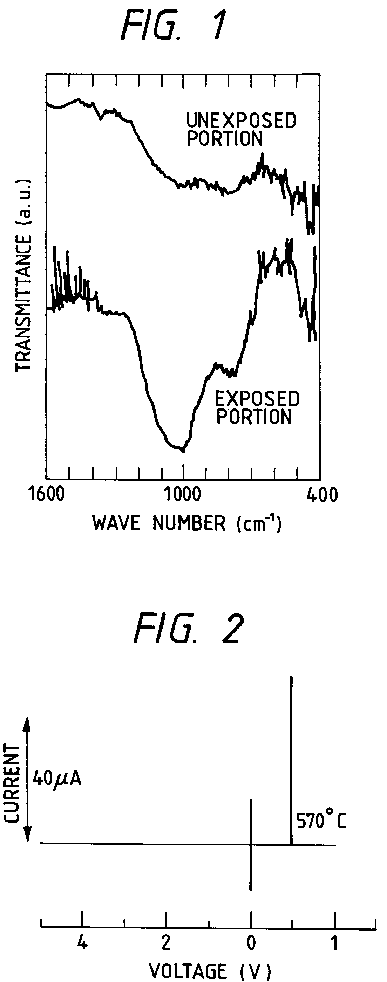

FIG.1 is a graph showing the infrared spectrums of the thin film described above in the exposed portion and the unexposed portion. The absorbance for the exposed portion markedly shows the signal of SiO₂ near wave number of 1020 cm⁻¹ and the absorbance for the unexposed portion markedly shows the signal of SiC near wave number of 800 cm ⁻¹. From this result, the effects of the exposing light and the heat treatment described above are clear.

### [Embodiment 2]

By forming a SiC thin film on an n-type silicon substrate using the poly(phenyl silyne) in the embodiment 1, the junction characteristic is studied from the current-voltage curve. The result is shown in FIG.2. By the heat treatment of the poly(phenyl silyne), it is possible to easily form an SiC/n-Si heterogeneous junction having rectifying property.

### [Embodiment 3]

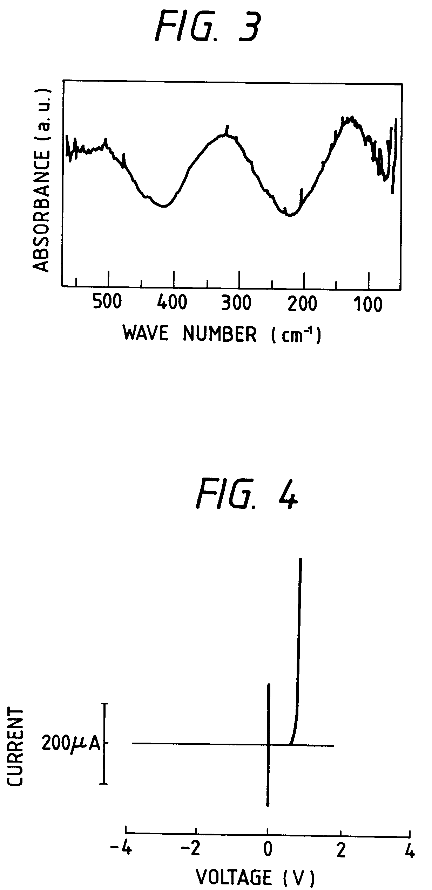

A solution of the poly(n-propyl silyne) synthesized as in the same way as in the embodiment 1 (using only the compound shown in the equation [1], R₁ is n-propyl group) of 20 wt% in toluene is coated on a silicon wafer with spin coating method. The specimen is exposed using a KrF excimer laser through a mask pattern in a vacuum, and then heat-treated at 350°C in a vacuum for 30 minutes. As the result, a positive pattern (thickness of 0.1 µm) having an L/S=0.25 µm at minimum in the exposed portion to in the unexposed portion can be formed. From the analysis of the far infrared spectrum shown in FIG.3, it is confirmed that an a-Si thin film is formed in the unexposed portion.

### [Embodiment 4]

Poly(n-propyl silyne) is synthesized using the compounds with the molar ratio of the equation [1] : the equation [2] =1 :4 (R₁, R₂, R₃ are n-propyl group), and a solution of the poly(n-propyl silyne) of 20 wt% in toluene is coated on a silicon wafer with spin coating method. The specimen is exposed using a KrF excimer laser through a mask pattern under a oxygen containing atmosphere, and then heat-treated at 500°C in a vacuum for 1 hour.

As the result, a negative pattern having an L/S =0.25 µm at minimum in the exposed portion to in the unexposed portion can be formed. As the negative pattern is observed using a microscope, it can be observed no crack due to contraction of the thin film during the heat treatment and it is confirmed that the formed pattern is extremely close-grained and uniform.

### [Embodiment 5]

A poly(n-propyl silyne) thin film is formed on an n-type silicon substrate using a solution of the poly(n-propyl silyne) 20 wt% in toluene with spin coating method. By heat treating the specimen at 400°C in a vacuum for 30 minutes, the poly(n-propyl silyne) thin film is changed to an amorphous silicon thin film. By doping phosphorous to the thin film as an impurity, a p-n junction of the n-type silicon and the p-type silicon thin film is formed. FIG.4 shows the result.

### [Embodiment 6]

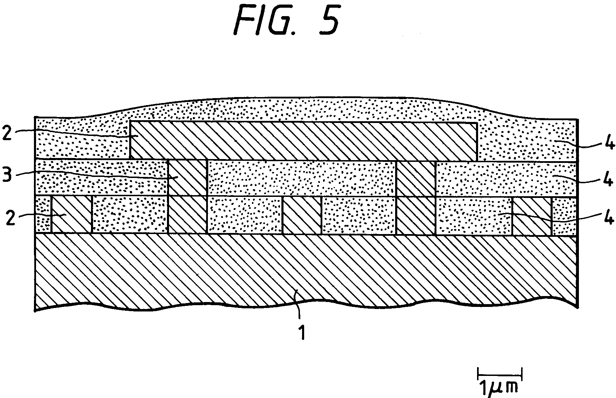

Poly(phenyl silyne) is synthesized in the same way as in the embodiment 1. A solution of the poly(phenyl silyne) of 30 wt% in toluene is applied on a silicon wafer having an aluminum pattern of L/S=1/1 µm and thickness 1 µm with spin coating method to form a film having thickness of 2 µm. After heat-treating the film at 400°C for 1 hour in the atmosphere, the applied surface is flattened by chemical-mechanical polishing (CMP). No clack is take place in the film also after polishing and a strong insulator film is obtained. The film has an insulating withstanding voltage of 600 V/µm and a specific dielectricity of 3.2. FIG.5 schematically shows the cross section of an aluminum double-layered wiring obtained by repeating the process described above. Aluminum wiring and via are formed by etching in the usual method the aluminum deposited by spattering method. An integrated circuit can be obtained by forming wiring on a silicon wafer having an active area. In FIG.5, the reference character 1 is a silicon wafer, the reference character 2 is aluminum wiring, the reference character 3 is an aluminum via, and the reference character 4 is an insulator film.

According to the present invention, by performing irradiation of electromagnetic wave and heat treatment after applying a thin film of polysilyne, it is possible to form a thin film having a function of electric conductivity (SiC), semiconductor property (a-Si), insulating property (SiO₂) or transparent property (SiO₂) on an inorganic substrate arbitrarily and easily. Thereby, it is possible to easily form a fine structure in a semiconductor or the like.

## Claims

1. A method of forming a thin film, the method comprising the steps of:
forming a thin film of Si and/or Fe network polymer on a substrate;
irradiating electromagnetic wave on the film if necessary; and then
heat-treating the substrate at 200°C to 1000°C.

2. A method of forming a thin film, the method comprising the steps of:
forming a thin film of Si and/or Ge network polymer on a substrate;
performing at least one of (1) process for irradiating electromagnetic wave on the film under an oxygen containing atmosphere and (2) process for heat-treating the substrate at 200°C to 1000°C under an oxygen containing atmosphere.

3. A method of forming a thin film according to claim 1, wherein said network polymer is a material formed by polymerizing organometallic compounds expressed by the following chemical equations [1] and [2]. 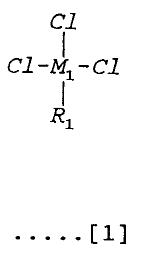 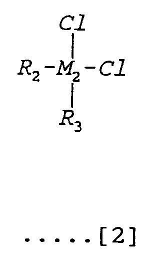 (Therein, M₁, M₂ are selected from the group consisting of Si and Ge, and may be the same. R₁, R₂, R₃ are selected from the group consisting of aliphatic group, aliphatic fluoride group, aromatic group, and aromatic fluoride group which have less than twenty carbon elements, and may be the same.)

4. A method of forming a thin film according to claim 3, wherein said network polymer is a material formed by polymerizing organometallic compounds expressed by the following chemical equations [1] and [2] using alkali metal or alkali metal alloy, copper and magnesium. 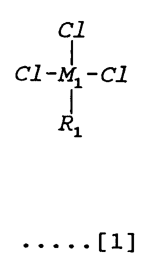 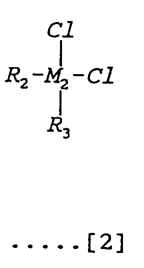 (Therein, M₁, M₂ are selected from the group consisting of Si and Ge, and may be the same. R₁, R₂, R₃ are selected from the group consisting of aliphatic group, aliphatic fluoride group and aromatic group which have less than ten carbon elements, and may be the same.)

5. An insulator thin film formed by the steps of:
forming a thin film of Si and/or Ge network polymer on a substrate;
irradiating electromagnetic wave on the film under an oxygen containing atmosphere if necessary; and then
heat-treating the substrate at 200°C to 1000°C.

6. A method of forming an insulator thin film, the method comprising the steps of:
forming a thin film of Si and/or Ge network polymer on a substrate;
irradiating electromagnetic wave on the film under an oxygen containing atmosphere if necessary; and then
heat-treating the substrate at 200°C to 1000°C.

7. An integrated circuit having an insulator thin film as an inter layer dielectric film including surface dielectric layer, wherein sid insulator thin film is formed by the steps of:
forming a thin film of Si and/or Ge network polymer on a substrate;
irradiating electromagnetic wave on the film under an oxygen containing atmosphere if necessary; and then
heat-treating the substrate at 200°C to 1000°C.

8. A method of manufacturing an integrated circuit having an insulator thin film as an inter layer dielectric including surface layer dielectric, wherein said insulator thin film is formed by the steps of:
forming a thin film of Si and/or Ge network polymer on a substrate;
irradiating electromagnetic wave on the film under an oxygen containing atmosphere if necessary; and then
heat-treating the substrate at 200°C to 1000°C.

9. An integrated circuit having an insulator thin film as an inter layer dielectric, wherein said insulator thin film is formed by the steps of:
forming a thin film of Si and/or Ge network polymer on a substrate;
irradiating electromagnetic wave on the film under an oxygen containing atmosphere if necessary;
heat-treating the substrate at 200°C to 1000°C; and
flattening the surface of said insulator thin film through chemical-mechanical polishing.

10. A method of manufacturing an integrated circuit having an insulator thin film as an inter layer dielectric, wherein said insulator thin film is formed by the steps of:
forming a thin film of Si and/or Ge network polymer on a substrate;
irradiating electromagnetic wave on the film under an oxygen containing atmosphere if necessary;
heat-treating the substrate at 200°C to 1000°C under; and
flattening the surface of said insulator thin film through chemical-mechanical polishing.

11. An electronic device having a thin film used for a conductor layer or semiconductor layer, wherein said thin film is formed by the steps of:
forming a thin film of Si and/or Ge network polymer on a substrate;
irradiating electromagnetic wave on the film under an oxygen containing atmosphere if necessary; and then
heat-treating the substrate at 200°C to 1000°C.

12. A method of manufacturing an electronic device having a thin film used for a conductor layer or semiconductor layer, wherein said thin film is formed by the steps of:
forming a thin film of Si and/or Ge network polymer on a substrate;
irradiating electromagnetic wave on the film under an oxygen containing atmosphere if necessary; and then
heat-treating the substrate at 200°C to 1000°C.

13. A method of forming an insulator film, the method comprising the steps of:
forming a thin film of Si and/or Ge network polymer on a substrate; and then
oxidizing said thin film.

14. An insulator film, which is formed by the steps of:
forming a thin film of Si and/or Ge network polymer on a substrate; and then
oxidizing said thin film.
